# EUROPÄISCHE PATENTSCHRIFT

(11) **EP 4 146 585 B1**
(45) Veröffentlichungstag und Bekanntmachung des Hinweises auf die Patenterteilung: **03.07.2024**
(21) Anmeldenummer: 21724618.0
(22) Anmeldetag: 05.05.2021
(51) Int. Cl.: B81B 3/00

(54) **DREHFEDERELEMENT**
TORSION SPRING ELEMENT
ÉLÉMENT DE RESSORT DE TORSION

(30) Priorität: 06.05.2020 DE 102020112267
(43) Veröffentlichungstag der Anmeldung: 15.03.2023
(73) Patentinhaber: Northrop Grumman LITEF GmbH, 79115 Freiburg (DE)
(72) Erfinder: RENDE, Jan Daniel, 79336 Herbolzheim (DE)
(74) Vertreter: Müller Hoffmann & Partner
(86) Internationale Anmeldenummer: PCT/EP2021/061903
(87) Internationale Veröffentlichungsnummer: WO 2021/224347

(56) Entgegenhaltungen:
- US-A1- 2019 234 991
- Teo Tat Joo ET AL: "Compliant Manipulators" In: "Handbook of Manufacturing Engineering and Technology", 1. Januar 2014 (2014-01-01), Springer London, London, XP055827495, ISBN: 978-1-4471-4976-7 Seiten 1-63, DOI: 10.1007/978-1-4471-4976-7_102-1, Gefunden im Internet: URL:https://www.researchgate.net/profile/T at-Joo-Teo/publication/279264596_Compliant _Manipulators/links/5afa56b2a6fdccacab16a4 fa/Compliant-Manipulators.pdf> Abbildung 1(b) Seite 2 - Seite 3
- WEN JIE CHEN ET AL: "A 3-DOF flexure-based fixture for passive assembly of optical switches", ADVANCED INTELLIGENT MECHATRONICS. PROCEEDINGS, 2005 IEEE/ASME INTERNA TIONAL CONFERENCE ON MONTEREY, CA JULY 24-28, 2005, PISCATAWAY, NJ, USA,IEEE, 24. Juli 2005 (2005-07-24), Seiten 618-623, XP032391504, DOI: 10.1109/AIM.2005.1511051 ISBN: 978-0-7803-9047-8

## Beschreibung

Die vorliegende Erfindung betrifft ein Drehfederelement, das geeignet ist, sowohl Drehbewegungen als auch translatorische Bewegungen auszuführen.

In mikro-elektro-mechanischen Systemen (MEMS) werden oftmals Federmechanismen verwendet, die hochgradig spezialisiert sind. Derartige Federmechanismen können z.B. eine sehr gut geführte, geradlinige Bewegung mit sehr guter Linearität der Kraft-Weg-Kurve entlang einer Richtung ermöglichen, während in dazu senkrechte Richtungen in erster Näherung keine Bewegung möglich ist. Ebenso sind Drehfedern bekannt, die reine Drehbewegungen ohne lineare Bewegung ermöglichen. US 2019/234991 A1 offenbart ein Drehfederelement, das Teil einer mikro-elektro-mechanischen Vorrichtung und einstückig ausgebildet ist.

In modernen und komplexen MEMS-Designs müssen Federmechanismen jedoch verschiedene Aufgaben erfüllen, was mit den bisher verwendeten, auf eine Bewegungsart spezialisierten Federmechanismen oft nicht zu leisten ist. Vielmehr müssen verschiedene Federmechanismen miteinander kombiniert werden, wie z.B. eine Drehfeder und eine Linearfeder. Dies führt zwangsläufig zu einem großen Platzbedarf. Zudem können sich die einzelnen Federmechanismen gegenseitig sperren, so dass die optimalerweise erreichbaren Auslenkungen der einzelnen Federmechanismen in der Kombination nicht realisiert werden können. Der große Platzbedarf vergrößert überdies die Gefahr, dass bei der Fertigung des MEMS, z.B. mittels Ätzen, Prozessschwankungen über die Fläche des kombinierten Federmechanismus auftreten, durch die Federcharakteristika innerhalb des Federmechanismus variieren.

Aufgabe der vorliegenden Erfindung ist es also, ein kompakt ausgebildetes Drehfederelement anzugeben, das verschiedenste Bewegungen ausführen kann. Diese Aufgabe wird durch den Gegenstand des Anspruch 1 gelöst.

Ein erfindungsgemäßes Drehfederelement ist drehbar mit einem Substrat verbunden und zum Einsatz in mikro-elektro-mechanischen Vorrichtungen geeignet und kann hierzu sowohl gegenüber dem Substrat verdreht als auch linear gegenüber dem Substrat bewegt werden und ist dadurch gekennzeichnet, dass das Drehfederelement einstückig ausgebildet ist.

Mit "einstückig ausgebildet" ist hierbei gemeint, dass das Drehfederelement keine Kombination von Federmechanismen ist, die auch für sich genommen funktionieren würden. Es ist also nicht möglich, Komponenten oder Verbindungselemente aus dem Drehfederelemente zu entfernen, ohne dass die Funktionsfähigkeit des Drehfederelements schwer beeinträchtig würde. Im Gegensatz dazu kann bei einer Kombination von mehreren auch einzeln verwendbaren Federmechanismen stets die Verbindung zwischen den Federmechanismen entfernt werden, ohne die Funktion der einzelnen Federmechanismen zu beeinträchtigen.

Durch die einstückige Ausgestaltung des Drehfederelements wird es möglich, eine drehbare und gleichzeitig linear verschiebbare Lagerung von MEMS-Komponenten über dem Substrat zu erreichen, ohne den Platzbedarf hierfür zu vergrößern.

Das Drehfederelement der Erfindung weist hierzu eine Rahmenstruktur, eine vorzugsweise innerhalb der Rahmenstruktur angeordnete Ankerstruktur und Federstrukturen auf, die die Ankerstruktur mit der Rahmenstruktur verbinden. Hierbei verbindet die Ankerstruktur die Federstrukturen und die Rahmenstruktur mit dem Substrat und die Rahmenstruktur bewegt sich unter Verformung der Federstrukturen als Ganzes gegenüber der Ankerstruktur, um Drehbewegungen und Linearbewegungen der Drehfeder gegenüber dem Substrat zu erzeugen.

Das Drehfederelement weist also eine außen liegende Rahmenstruktur auf, die zum Anschluss von anderen MEMS-Komponenten an das Drehfederelement dienen kann. Die Rahmenstruktur verschiebt und/oder verdreht sich gegenüber dem Substrat und der Ankerstruktur unter Verformung der Federstrukturen, die die Rahmenstruktur über dem Substrat halten. Sowohl Rotationen als auch Translationen werden durch die Federstrukturen vermittelt. Es ist also keine Mehrzahl von Federmechanismen vorhanden. Auf diese Weise lässt sich das Drehfederelement einstückig und kompakt ausbilden. Dabei kann die Rahmenstruktur selbst mehr oder weniger steif ausgebildet sein. Die Rahmenstruktur kann also Rotationen und Translationen formstabil ausführen. Sie kann aber auch ganz oder teilweise aus Segmenten bestehen, die selbst Federeigenschaften aufweisen.

Die Federstruktur der Erfindung weist zumindest eine Paarung von zwei Biegebalkenfedern auf, die sich von der Ankerstruktur aus unter einem Winkel ungleich 0° erstrecken, jeweils einen Knick aufweisen, nach dem Knick aufeinander zulaufen, an der Rahmenstruktur aufeinandertreffen und dort mit der Rahmenstruktur verbunden sind.

Ausgehend von der Ankerstruktur fächern also zwei Biegebalkenfedern auf. Der Abstand zwischen den Biegebalkenfedern vergrößert sich mit zunehmendem Abstand von der Ankerstruktur bevor die Biegebalkenfedern wieder aufeinander zulaufen, um sich an der Rahmenstruktur miteinander und mit der Rahmenstruktur zu verbinden. Die im Verlauf der Biegebalkenfedern auftretende Richtungsänderung wird hier als "Knick" bezeichnet. Dies soll jedoch nur die Tatsache der Richtungsänderung beschreiben und auch abgerundete Biegungen oder graduelle Richtungsänderungen umfassen.

Die beiden Biegebalkenfedern formen damit in etwa ein Viereck, dessen eines gegenüberliegendes Eckenpaar die Verbindungen zur Anker- und zur Rahmenstruktur ist und dessen anderes gegenüberliegendes Eckenpaar die Knickstellen sind. Die den Knickstellen entsprechenden Ecken können hierbei abgerundet sein, so dass das Viereck zu einer bikonvexen Linsenform entartet ist. Das Viereck kann hierbei vorzugsweise die Form eines Drachenvierecks, weiter vorzugsweise die Form einer Raute und weiter vorzugsweise quadratische Form (oder die entsprechende Entartung zur Linsenform) aufweisen.

Jede der Biegebalkenfedern kann sich hierbei in bekannter Weise verformen. Durch die vorhandenen Knicke und die gegenüberliegenden Verbindungen der Biegebalkenfedern lassen sich sowohl Linear- als auch Rotationsbewegungen des Verbindungspunkt zur Rahmenstruktur in Bezug auf den Verbindungspunkt zur Ankerstruktur erzeugen. Stauchen oder strecken sich beide Biegebalkenfedern um den gleichen Betrag, so bewegen sich die beiden Verbindungspunkte auf einer Geraden aufeinander zu bzw. voneinander weg. Staucht sich eine Biegebalkenfeder während die andere sich streckt, resultiert eine Drehbewegung. Durch verschiedene Belastungen an den Biegebalkenfedern lassen sich auf einfache Weise verschiedene Bewegungsmuster realisieren. Insbesondere sind lineare Bewegungen entlang mehrerer Richtungen möglich.

Eine derartige Drehfeder ist also komplexen Anforderungsprofilen gewachsen, ohne einen vergrößerten Platzbedarf zu haben. Zudem schränken die Biegebalkenfedern ihre gegenseitige Beweglichkeit nicht ein, wodurch maximale Auslenkungen erreicht werden können.

Die Federstrukturen können eine Mehrzahl von Paarungen von Biegebalkenfedern aufweisen, wie sie oben beschrieben wurden. Sich benachbarte Biegebalkenfedern von unterschiedlichen Paarungen können sich bis zu dem jeweiligen Knick geradlinig und parallel von der Ankerstruktur aus erstrecken. Von der Ankerstruktur aus laufen also stets zwei Biegebalkenfedern parallel nach außen. An einem vorgegebenen Punkt biegen oder knicken die Biegebalkenfedern seitlich weg, um sich an der Rahmenstruktur mit der anderen Biegebalkenfeder der jeweiligen Paarung zu treffen. Hierdurch wird die Drehfeder in mehrere Richtungen stabilisiert. Dies erlaubt es, MEMS-Komponenten von verschiedenen Richtungen aus an die Drehfeder anzuschließen. Zudem können dadurch mehr Bewegungsmuster sicher geführt werden. Hierdurch lässt sich die Drehfeder flexibler einsetzen.

Die Federstrukturen können die Mehrzahl von Paarungen von Biegebalkenfedern aufweisen, wobei sich alle Biegebalkenfedern der unterschiedlichen Paarungen unter dem gleichen Winkel von der Ankerstruktur aus erstrecken. Hierdurch entsteht ein symmetrischer Aufbau der Drehfeder, der stabiler gegenüber Belastungen ist. Die Drehfeder wird hierdurch verlässlicher.

Die Rahmenstruktur kann ein rechteckiger, an einer Längsseite offener Rahmen sein und die Ankerstruktur kann ein mit dem Substrat verbundener Sockel sein, der mittig an der offenen Längsseite des Rahmens angeordnet ist. Eine erste Biegebalkenfeder läuft von dem Sockel aus parallel zur Längsrichtung des Rahmens bis zu einem ersten Ende des Rahmens, knickt dort um 90° ab und läuft zu einer ersten Ecke des Rahmens und ist dort mit dem Rahmen verbunden. Eine zweite Biegebalkenfeder läuft von dem Sockel aus senkrecht zur Längsrichtung zu einer geschlossenen Längsseite des Rahmens, knickt dort um 90° ab und läuft zu der ersten Ecke des Rahmens und ist dort mit dem Rahmen verbunden. Eine dritte Biegebalkenfeder läuft von dem Sockel aus parallel zur Längsrichtung des Rahmens und entgegengesetzt zur ersten Biegebalkenfeder bis zu einem zweiten Ende des Rahmens, knickt dort um 90° ab und läuft zu einer zweiten Ecke des Rahmens und ist dort mit dem Rahmen verbunden. Eine vierte Biegebalkenfeder läuft von dem Sockel aus parallel zur zweiten Biegebalkenfeder senkrecht zur Längsrichtung zu der geschlossenen Längsseite des Rahmens, knickt dort um 90° ab und läuft entgegengesetzt zur zweiten Biegebalkenfeder zu der zweiten Ecke des Rahmens und ist dort mit dem Rahmen verbunden. Durch diese konkrete Struktur lassen sich rechteckige Drehfederelemente realisieren, die gegenüber einem Substrat sowohl Rotationen als auch lineare Bewegungen ausführen können.

Die Rahmenstruktur kann ein quadratischer Rahmen sein und die Ankerstruktur kann ein im Mittelpunkt des Rahmens mit dem Substrat verbundener Sockel sein. Acht Biegebalkenfedern laufen hierbei in Paaren von je zwei parallel laufenden Biegebalkenfedern von dem Sockel aus in Richtung des Rahmens, knicken am Rahmen um 90° ab und laufen parallel zum Rahmen zu der nächstgelegenen Ecke des Rahmens und sind dort mit dem Rahmen verbunden. Durch diese konkrete Struktur lassen sich quadratische Drehfederelemente realisieren, die gegenüber einem Substrat sowohl Rotationen also auch lineare Bewegungen ausführen können. Diese quadratischen Drehfederelemente entsprechen hierbei einer Verdopplung der oben beschriebenen rechteckigen Drehfederelemente.

Die Rahmenstruktur kann auch ein kreisförmiger Rahmen sein und die Ankerstruktur kann ein im Mittelpunkt des Rahmens mit dem Substrat verbundener Sockel sein. Paare von je zwei parallel laufenden Biegebalken können wie die Speichen eines Rades von dem Sockel aus in Richtung des Rahmens laufen, am Rahmen um 90° abknicken und entlang des Rahmens laufen. Benachbarte Biegebalkenfedern aus benachbarten Paaren treffen sich dann in der Mitte zwischen ihren jeweiligen Knickstellen und sind dort mit dem Rahmen verbunden. Hierdurch lassen sich runde Drehfederelemente realisieren. Die Federkonstante derartiger Drehfeder kann über die Anzahl der "Speichen", d.h. über die Anzahl von Biegebalkenfedern eingestellt werden.

Mit der Grundstruktur der zunächst voneinander weglaufenden und dann wieder aufeinander zulaufenden Biegebalkenfedern, die auf der einen Seite mit der Ankerstruktur und der anderen Seite mit der Rahmenstruktur verbunden sind, lassen sich also eine Vielzahl von verschiedenen Drehfederelementen konstruieren. All diesen Drehfederelemente ist gemeinsam, dass sie einstückig ausgebildet und in der Lage sind, sowohl Rotationsbewegungen als auch lineare Bewegungen gegenüber dem Substrat auszuführen.

Dies wird im Folgenden mit Bezug auf die beigefügten Figuren weiter erläutert. Die folgende Beschreibung ist dabei aber rein beispielhaft. Die Erfindung ist allein durch den Gegenstand der Ansprüche bestimmt. Es zeigt:
- **Fig. 1**: eine schematische Darstellung eines Drehfederelements;
- **Fig. 2**: schematische Darstellungen eines weiteren Drehfederelements;
- **Fig. 3**: schematische Darstellungen von verschiedenen weiteren Drehfederelementen;
- **Fig. 4**: schematische Darstellungen von verschiedenen weiteren Drehfederelementen;
- **Fig. 5**: schematische Darstellungen von verschiedenen weiteren Drehfederelementen;
- **Fig. 6**: eine schematische Darstellung eines weiteren Drehfederelements;
- **Fig. 7**: eine schematische Darstellung eines weiteren Drehfederelements;
- **Fig. 8**: eine schematische Darstellung einer Rotation des Drehfederelements der Fig. 6; und
- **Fig. 9**: eine schematische Darstellung einer Translation des Drehfederelements der Fig. 6; und
- **Fig. 10**: eine schematische Darstellung eines weiteren Drehfederelements.

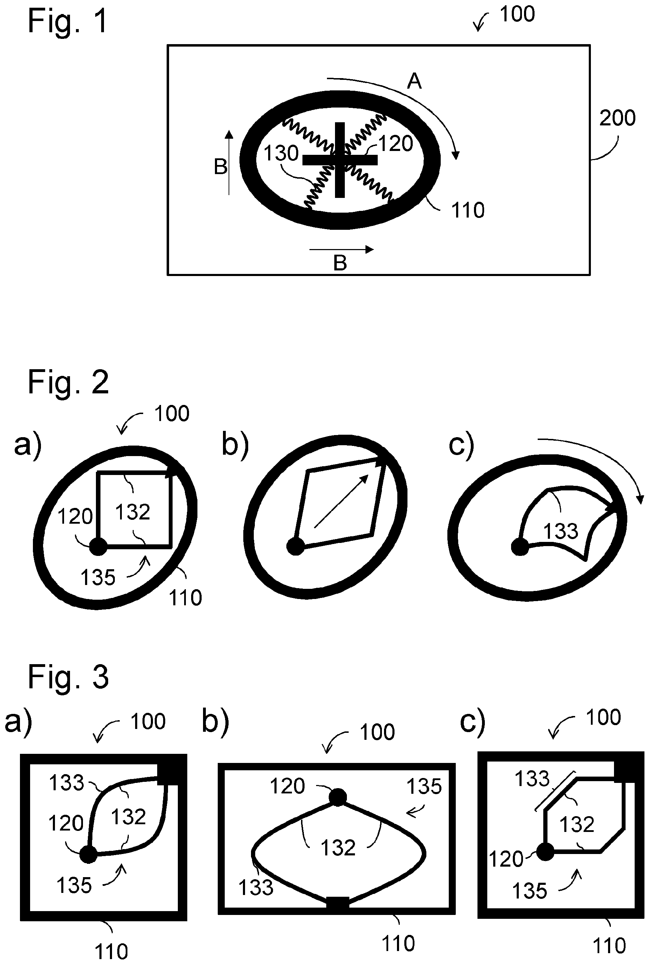

Die Figuren 2-10 zeigen Ausführungsbeispiele der Erfindung. Die Figur 1 dient zur Erklärung der Erfindung, zeigt jedoch nicht sämtliche Merkmale der Erfindung. Im Folgenden werden mit Bezug auf die Figuren verschiedene Varianten für ein einstückig ausgebildetes Drehfederelement 100 erläutert, das sowohl Rotationsbewegungen als auch lineare Bewegungen mit Bezug auf ein Substrat 200 ausführen kann, mit dem es verbunden ist. Es versteht sich von selbst, dass nicht sämtliche Varianten für derartige Drehfederelemente 100 diskutiert werden können. Die folgenden Erläuterungen sind deshalb rein beispielhaft. Ausschlaggebend ist die kompakte Gestaltung der vorliegenden Drehfederelemente 100, die sich aus der einstückigen Ausgestaltung bei gleichzeitiger Eignung zur Rotation und Translation ergibt.

Ein Beispiel für ein derartiges Drehfederelement 100 ist schematisch in der Fig. 1 gezeigt. Das Drehfederelement 100 ist mittels einer Ankerstruktur 120 über einem Substrat 200 gelagert. Das Substrat 200 kann hierbei als Teil des Drehfederelements 100 angesehen werden. Insbesondere ist das Drehfederelement 100 durch an sich bekannte Prozessschritte der Halbleiter- und/oder MEMS-Technologie aus bzw. auf dem Substrat gefertigt, z.B. durch verschieden Ätzschritte.

An die Ankerstruktur 120 des Drehfederelements 100 schließen sich Federstrukturen 130 an, die die Ankerstruktur 120 mit einer Rahmenstruktur 110 verbinden. Die Rahmenstruktur 110 bewegt sich unter Verformung der Federstrukturen 130 gegenüber dem Substrat 200 und der Ankerstruktur 120. Weitere Komponenten einer MEMS-Vorrichtung, in der das Drehfederelement 100 verwendet wird, sind daher mit der Rahmenstruktur 110 verbunden.

Rahmenstruktur 110, Ankerstruktur 120 und die Federstrukturen 130 sind in der Fig. 1 nur rein symbolhaft dargestellt. So können die Rahmenstruktur 110 und die Ankerstruktur 120 im Prinzip jede beliebige Form aufweisen, solange sie von den Federstrukturen 130 beweglich verbunden werden können. Auch kann die Rahmenstruktur 110 relative unflexibel sein oder aber zumindest in Teilen Federeigenschaften aufweisen, die auch Relativbewegungen einzelner Teile der Rahmenstruktur 110 gegeneinander erlauben, so wie etwa gegenläufige Schwingungen der verschiedenen Teile. Auch die Darstellung der Federstrukturen 130 als Spiralfedern dient nur der symbolischen Kenntlichmachung ihrer Federeigenschaften. Die Federstrukturen 130 können jede mittels Halbleiter- und/oder MEMS-Verfahren herstellbare Form aufweisen, die es erlaubt, die Rahmenstruktur 110 gegenüber der Ankerstruktur 120 zu verdrehen oder zu verschieben, wie das in der Fig. 1 durch die Pfeile A und B dargestellt ist. Insbesondere kann die Federstruktur 130 jede lineare Bewegungen parallel zum Substrat 200 erlauben, d.h. parallel zur Bildebene der Fig. 1.

Wie bereits aus der schematischen Darstellung der Fig. 1 zu sehen ist, besteht das Drehfederelement 100 nicht aus mehreren Komponenten, die für sich genommen Rotationen oder Translationen ermöglichen können, sondern ist einstückig aufgebaut. Eine Trennung der Rotationsfunktion von der Translationsfunktion durch Entfernen einzelner Bestandteile des Drehfederelements 100 ist daher nicht möglich. Das Drehfederelement 100 zeichnet sich also durch einen kompakten Aufbau aus, der die Multifunktionalität des Drehfederelements 100 erzeugt.

Eine mögliche Realisierung des Drehfederelementes 100 ist in der Fig. 2 gezeigt. Das Drehfederelement 100 weist die im Prinzip beliebig gestaltete Rahmenstruktur 110 auf, innerhalb derer sich die ebenfalls im Prinzip beliebig gestaltete Ankerstruktur 120 befindet. Die Rahmenstruktur 110 ist hier zwar als geschlossene Struktur gezeigt, sie kann aber auch offen sein. Auch kann die Ankerstruktur außerhalb der Rahmenstruktur 110 liegen.

Als Federstrukturen 130 dienen hier eine Paarung 135 von Biegebalkenfedern 132, die sich von der Ankerstruktur 120 zu der Rahmenstruktur 110 erstrecken. Die Biegebalkenfedern 132 laufen hierbei zunächst auseinander, weisen einen Knick 133 auf und laufen dann derart aufeinander zu, dass sie sich an der Rahmenstruktur 110 treffen (vgl. Fig. 2a)).

Wie in den Fig. 2b) und 2c) gezeigt ermöglicht diese Ausbildung der Federstrukturen 130 sowohl lineare Relativbewegungen zwischen Rahmenstruktur 110 und Ankerstruktur 120 als auch Drehbewegungen. Durch entsprechende Verformung der Biegebalkenfedern 132 lassen sich zudem verschiedene Linearbewegungen realisieren. Neben der in der Fig. 2b) gezeigten Diagonalbewegung, die durch gemeinsames Stauchen/Strecken beider Biegebalkenfedern 132 erzeugt wird, können z.B. durch das Feststehen der horizontalen Abschnitte der gepaarten Biegebalkenfedern bei Verformung der vertikal stehenden Abschnitte Bewegungen in horizontaler Richtung erzeugt werden. Darüber hinaus lässt das Stauchen einer Biegebalkenfeder 132 bei gleichzeitigem Dehnen der anderen Biegebalkenfeder 132 die Rahmenstruktur 110 um die Ankerstruktur 120 rotieren. Die Paarung 135 von Biegebalkenfedern 132 macht das Drehfederelement 100 also bei kleinstem Platzbedarf multifunktional.

Die Biegebalkenfedern 132 sind in der Fig. 2 so dargestellt, dass sie im entspannten Zustand ein Rechteck bzw. ein Quadrat einschließen. Der Knick 133 ist hierbei also ein abrupter Richtungswechsel. Wie in den Fig. 3a) bis 3c) dargestellt, kann der Knick 133 aber auch allgemeiner als Richtungswechsel aufgefasst werden, der graduell (Fig. 3a) und 3b)) oder in mehreren Stufen (Fig. 3c)) erfolgt. Ausschlaggebend ist hierbei, dass die Biegebalkenfedern 132 zunächst voneinander weg und dann wieder aufeinander zu laufen. Biegebalkenfedern 132, die aus geraden Segmenten bestehen, lassen sich hierbei jedoch leichter mittels lithographischen Verfahren herstellen.

Die Verbindung zwischen der Paarung 135 von Biegebalkenfedern 132 und der Rahmenstruktur 110 kann hierbei ebenfalls beliebig ausgebildet sein, insbesondere an einer beliebigen Stelle der Rahmenstruktur 110. Wie in den Figuren gezeigt kann die Rahmenstruktur 110 einen Steg oder dergleichen aufweisen, in den die Biegebalkenfedern 132 münden. Die Biegebalkenfedern 132 können aber auch direkt in die Rahmenstruktur 110 münden und dazu leicht beabstandet voneinander sein. Dies ist unschädlich, solange gedachte Verlängerungen der Biegebalkenfedern 132 sich in der Rahmenstruktur 110 oder im Bereich der Rahmenstruktur 110 schneiden.

Wie mit Bezug auf die folgenden Figuren diskutiert wird, können die Federstrukturen 130 eine Mehrzahl von Paarungen 135 von Biegebalkenfedern 132 aufweisen, wie sie oben beschrieben wurde. Dies erlaubt es, das Drehfederelement 100 in verschiedene Richtungen zu stabilisieren und durch Positionierung und Ausgestaltung der Biegebalkenfedern 132 die Federkonstanten für Linearbewegungen und Rotationen des Drehfederelements 100 (nahezu) nach Belieben einzustellen.

Aus prozesstechnischer Sicht kann es hierbei vorteilhaft sein, wenn sich benachbarte Biegebalkenfedern 132 von benachbarten Paarungen 135 parallel zueinander von der Ankerstruktur 120 weg erstrecken. Die parallele Führung der Biegebalkenfedern 132 erleichtert die Herstellung mittels eines Ätzvorgangs, da nur ein linearer Graben zwischen den parallelen Biegebalkenfedern 132 geätzt werden muss.

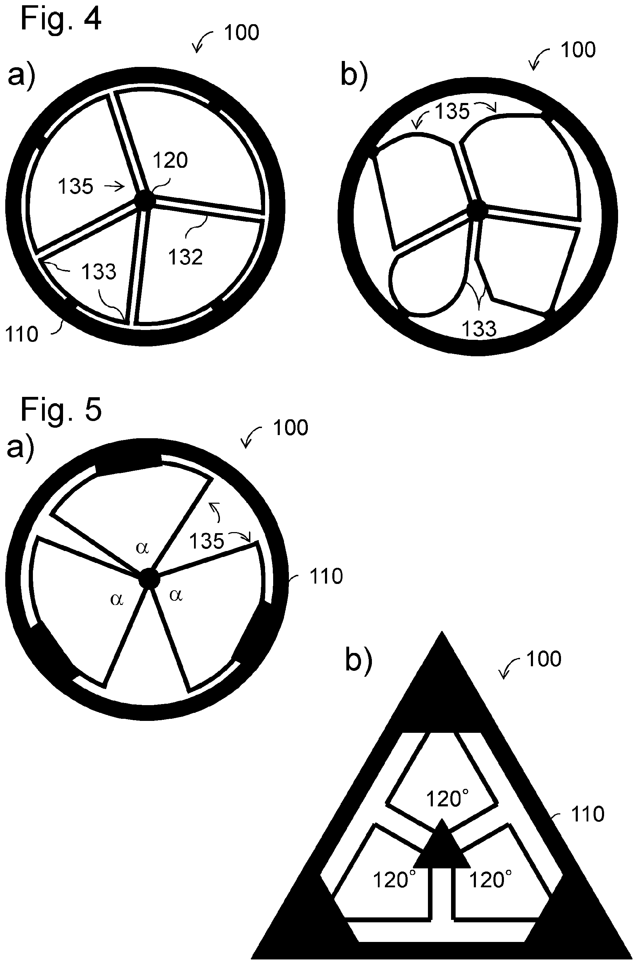

Wie in der Fig. 4 gezeigt können diese parallelen Biegebalkenfedern 132 sich wie die Speichen eines Rades radial nach außen erstrecken, bevor sie abknicken und mit der jeweils anderen Biegebalkenfeder 132 ihrer Paarung 135 in Richtung der Rahmenstruktur zusammenlaufen. Die "Speichen" können dabei gleich oder unregelmäßig über den Umfang des Rades verteilt sein.

Wie in der Fig. 4a) gezeigt können die Biegebalkenfedern 132 bis zu der Rahmenstruktur 110 (hier ein kreisförmiger Rahmen) laufen, dort abknicken und parallel zur Rahmenstruktur aufeinander zulaufen. Die Verbindung zum Rahmen kann dann z.B. symmetrisch zwischen den Knickstellen 133 liegen. Die Verbindung kann aber auch asymmetrisch angeordnet sein. Auch diese Anordnung hat den Vorteil, dass die parallel zum Rahmen verlaufenden Biegebalkenfedern 132 relative leicht durch Ätzverfahren hergestellt werden können, indem ein Graben zwischen Rahmenstruktur 110 und Biegebalkenfeder 132 geätzt wird.

Alternativ können die Biegebalkenfedern 132 nach dem parallelen Verlauf auch ungeregelt abknicken und z.B. runde oder gestufte Knickstellen 133 aufweisen. Die Biegebalkenfedern 132 der verschiedenen Paarungen laufen dann in beliebiger, für die gewünschten Federeigenschaften vorteilhafter Form aufeinander zu. Dies ermöglicht eine größere Flexibilität.

Die Biegebalkenfedern 132 verschiedener Paarungen 135 brauchen sich jedoch nicht notwendigerweise in paralleler Weise von der Ankerstruktur weg erstrecken. Es kann auch ein beliebiger Winkel zwischen den Biegebalkenfedern 132 benachbarter Paarungen 135 liegen. Auch dies erhöht die Flexibilität beim Design des Drehfederelements 100.

Eine weitere Alternative für die Ausgestaltung der Paarungen 135 ist in der Fig. 5 gezeigt. So können die beiden Biegebalkenfedern 132 jeder Paarung 135 den gleichen Winkel α einschließen. Hierdurch lässt sich die Federkonstante gegenüber Drehbewegungen über einen größeren Winkelbereich konstant halten.

Beispiele hierfür sind in den Fig. 5a) und 5b) gezeigt. In der Fig. 5a) ist die Summe der Zwischenwinkel 3α kleiner als 360°. Benachbarte Paarungen 135 weisen also keine parallelen Biegebalkenfedern 132 auf. Falls dies von Vorteil ist, können die Paarungen 135 ungleichmäßig und nicht rotationssymmetrisch um die Ankerstruktur 120 herum verteilt werden, wie in der Fig. 5a) gezeigt. Bei einem symmetrischen Aufbau verbessert sich jedoch die Linearität der Federkonstanten gegenüber Drehungen.

Besonders vorteilhaft sind Ausgestaltungen, bei denen das Drehfederelement 100 symmetrisch mit geradlinig verlaufenden Biegebalkenfedern 132 aufgebaut ist, die möglichst parallel zueinander und zur Rahmenstruktur 110 verlaufen. Dies ist in der Fig. 5b) für ein Drehfederelement mit Rotationssymmetrie für 120°-Rotationen gezeigt. Die Biegebalkenfedern 132 der einzelnen Paarungen schließen jeweils einen Winkel von 120° ein. Alle Biegebalkenfedern 132 laufen zunächst senkrecht zu einem als Rahmenstruktur 110 dienenden dreieckigen Rahmen. Biegebalkenfedern 132 benachbarter Paarungen 135 laufen hierbei parallel. Am Rahmen knicken alle Biegebalkenfedern um 90° ab und laufen auf die Ecken des Dreiecksrahmens zu. Dort münden sie in Stege der Rahmenstruktur 110 und verbinden so die als Sockel ausgebildete Ankerstruktur 120 mit der Rahmenstruktur 110.

Diese Drehfeder ist für große Drehwinkel linear. Zudem hat sie für lineare Bewegungen in die Richtungen jeder der Dreiecksecken die gleiche Federkonstante. Dieses Drehfederelement 100 eignet sich also besonders für MEMS mit dreizähliger oder sechszähliger Symmetrie, d.h. zum Beispiel für ein aus Waben aufgebautes MEMS.

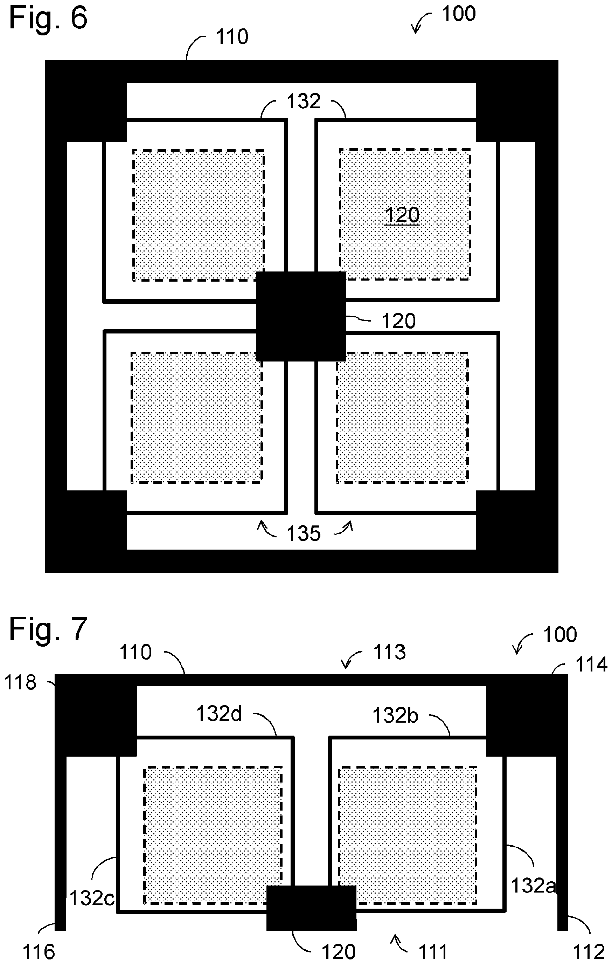

In ähnlicher Weise gibt die Fig. 6 ein für MEMS mit rechteckiger oder quadratischer Grundstruktur geeignetes Drehfederelement 100 wieder. Das Drehfederelement 100 weist einen quadratischen Rahmen als Rahmenstruktur 110 auf. Von einer als Sockel ausgebildeten Ankerstruktur 120 in der Mitte des quadratischen Rahmens erstrecken sich acht Biegebalkenfedern zunächst senkrecht zur Außenwand des Rahmens, um dann am Rahmen um 90° abzuknicken und parallel zum Rahmen auf die Ecken des Rahmens zuzulaufen. Dort münden sie in Verbindungsstege bzw. -sockel. Die vier Paarungen 135 von Biegebalkenfedern 132 formen also jeweils einen quadratischen oder rechteckigen Rahmen.

Das Drehfederelement 100 der Fig. 6 hat eine hochgradig lineare Federkonstante bezüglich Drehungen. Zudem können die Linearbewegungen des Drehfederelements 100 in vier Hauptrichtungen mit jeweiligen Federkonstanten aufgeteilt werden. Der Rahmen des Drehfederelements 100 kann sich horizontal, vertikal, sowie entlang der beiden Diagonalen des Quadrats bewegen. Durch die symmetrische Ausgestaltung des Drehfederelements 100 sind die Federkonstanten für Bewegungen in horizontaler und vertikaler Richtung (d.h. parallel zu den Seiten des Rahmens) gleich. Ebenso sind die Federkonstanten für die beiden Diagonalbewegungen gleich, unterscheiden sich aber von der Federkonstante für Horizontal-/Vertikalbewegungen.

In der Fig. 6 ist zudem eine mögliche Abwandlung der Ankerstruktur 120 durch schraffierte quadratische Flächen gezeigt. Diese Flächen liegen innerhalb der Paarungen 135 von Biegebalkenfedern 132. Bei der Fertigung des Drehfederelements 100 kann es von Vorteil sein, derartige Flächen in einem Ätzprozess stehen zu lassen. Die Biegebalkenfedern 132 können dann durch Ätzen von geraden Gräben auf beiden Seiten der Biegebalkenfedern 132 geformt werden. Auf der einen Seite einer Biegebalkenfeder 132 bleibt die Rahmenstruktur 110 stehen, auf der anderen Seite die Ankerstruktur 120. Dadurch kann das Drehfederelement 110 in einfacher Weise mit bekannten Herstellungsverfahren gefertigt werden.

Die Fig. 7 zeigt eine weitere Variante des Drehfederelements 100. Das Drehfederelement 100 der Fig. 7 kann als eine Halbierung des Drehfederelements 100 der Fig. 6 aufgefasst werden. Dementsprechend weist das Drehfederelement 100 der Fig. 7 (bei gleicher Größe der Längsseiten der Drehfederelemente 100 und gleicher Dimensionierung der innenliegenden Komponenten) Federkonstanten auf, die nur halb so groß sind, wie die Federkonstanten des Drehfederelements 100 der Fig. 6. Insbesondere können an verschiedenen Stellen des Substrats 200 angeordnete Drehfederelemente 100, wie sie in den Fig. 6 und 7 gezeigt sind, im gleichen Prozessschritt geätzt werden, sodass Biegebalkenfedern 132, Rahmenstrukturen 110 und Ankerstrukturen 120 exakt die gleichen Abmessungen aufweisen. Hierdurch können Systeme realisiert werden, für die eine Kombination von verschiedenen Drehfederelementen 100 mit aufeinander abgestimmten Federkonstanten vorteilhaft ist.

Bei dem Drehfederelement 100 der Fig. 7 liegt die Ankerstruktur 120 in der Mitte der durch die Halbierung des Drehfederelements der Fig. 6 entstandenen offenen Längsseite 111 der rechteckförmigen Rahmenstruktur 110. Eine erste Biegebalkenfeder 132a und eine zweite Biegebalkenfeder 132b formen ebenso wie eine dritte Biegebalkenfeder 132c und eine vierte Biegebalkenfeder 132d eine Paarung 135 von Biegebalkenfedern 132. Die erste und die dritte Biegebalkenfeder 132a, 132c laufen dabei zunächst in entgegengesetzter Richtung parallel zur Längsrichtung der Rahmenstruktur 110 auf ein erstes Ende 112 bzw. ein zweites Ende 116 des Rahmens zu. Dort knicken sie um 90° ab und laufen auf eine erste Ecke 114 bzw. eine zweite Ecke 118 zu, wo sie über jeweilige Sockel mit dem Rahmen verbunden sind. Senkrecht zur offenen Längsseite 111 und parallel zueinander laufen die zweite und die vierte Biegebalkenfeder 132b, 132d auf die geschlossene Längsseite 113 des Rahmens zu, knicken dort um 90° ab und laufen parallel zur geschlossenen Längsseite 113 bis zu der ersten bzw. zweiten Ecke 114, 118, um dort ebenfalls in die Sockel zu münden. Damit entspricht die Biegebalkenfeder 100 der Fig. 7 genau der Halbierung der Biegebalkenfeder der Fig. 6.

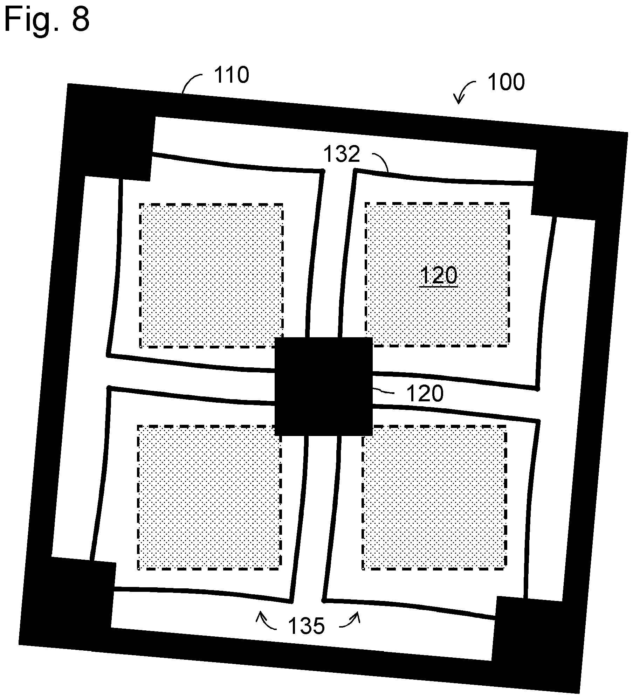

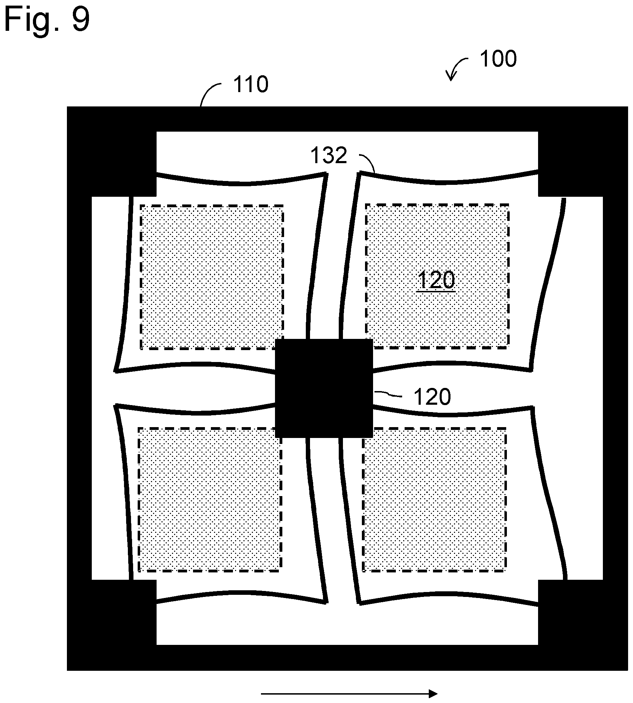

Die Fig. 8 und 9 zeigen der besseren Veranschaulichung halber eine Drehbewegung und eine Linearbewegung des Drehfederelements 100 der Fig. 6.

In der Fig. 8 wird die Rahmenstruktur 110 des Drehfederelements 100 im Uhrzeigersinn gegenüber der Ankerstruktur 120 verdreht. Aufgrund dieser Drehung dehnt sich jeweils eine Biegebalkenfeder 132 jeder der vier Paarungen 135, während die andere Biegebalkenfeder 132 sich staucht. Je nach Dimensionierung der Biegebalkenfedern 132, der Ankerstruktur 120 und der Rahmenstruktur 110 ermöglicht dies relativ große Drehungen.

Wie in der Fig. 9 gezeigt kann das gleiche Drehfederelement 100 auch lineare Verschiebungen der Rahmenstruktur 110 gegenüber der Ankerstruktur 120 realisieren, z.B. in horizontaler Richtung. Hierbei biegen sich insbesondere die senkrecht zur Translationsrichtung stehenden Abschnitte der Biegebalkenfedern 132, während sich die in Translationsrichtung liegenden Abschnitte aufgrund des Drucks nur leicht stauchen. Da das Drehfederelement 100 symmetrisch aufgebaut ist, erfolgen Verschiebungen nach oben, unten, links und rechts mit der gleichen Federkonstante. Verschiebungen entlang der Diagonalen können als Kombination der rein horizontalen und vertikalen Bewegungen angesehen werden und erfolgen damit mit entsprechend kombinierten Federkonstanten. Die Verschiebungsamplituden können hierbei relativ groß sein.

Wie oben dargelegt lassen sich durch einstückig ausgebildete Drehfederelemente verschiedene Funktionalitäten auf geringem Raum realisieren. Dies bietet die Möglichkeit neuartige und/oder verbesserte MEMS-Vorrichtungen bereitzustellen.

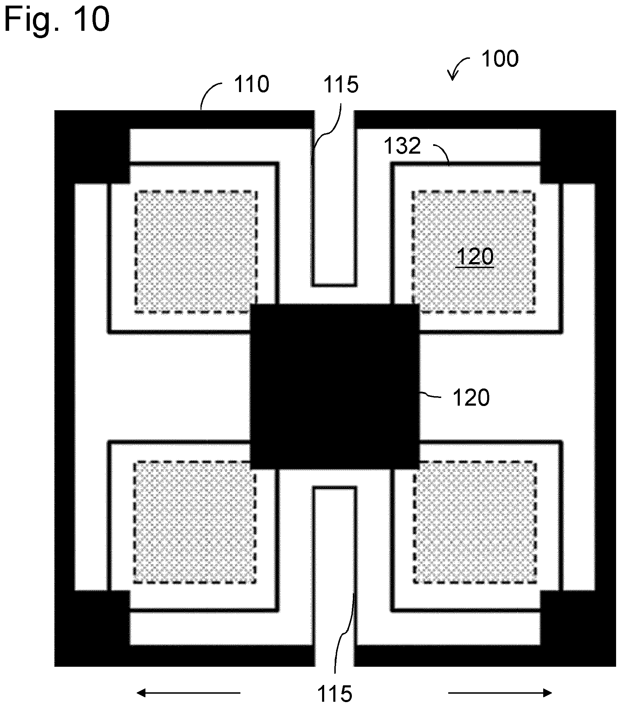

Die Fig. 10 zeigt eine Abwandlung des Drehfederelements 100 der Fig. 6, bei der die Rahmenstruktur 110 flexible Abschnitte aufweist, die in der Fig. 10 als Federn 115 dargestellt sind.

Dadurch weist das Drehfederelement 100 verschiedene translatorische Moden auf. Zum einen translatorische Moden, bei denen die linke und die rechte Hälfte des Drehfederelements 100 in die gleiche Richtung, d.h. im Gleichtakt schwingen. Diese Moden entsprechen im Wesentlichen den Translationen, die mit Bezug auf die Fig. 9 beschrieben wurden.

Zum anderen können auch translatorische Moden angeregt werden, in denen die Federn 115 derart verformt werden, dass sich die linke und die rechte Hälfte des Drehfederelements gegenläufig zueinander bewegen, d.h. im Gegentakt. Dies ist in der Fig. 10 durch die Pfeile unterhalb des Drehfederelements 100 angedeutet.

Es versteht sich von selbst, dass alternativ oder zusätzlich auch Federn 115 in den in der Fig. 10 senkrecht verlaufenden Teilen der Rahmenstruktur 110 aufgenommen sein können, um die rechts und links gezeigten Hälften des Drehfederelements 100 gegenläufig nach unten und oben schwingen zu lassen.

Durch die Verwendung von teilweise oder vollständig flexiblen Rahmenstrukturen 110 können die Funktionalitäten der oben beschriebenen Drehfederelemente 100 also weiter flexibilisiert werden.

## Patentansprüche

1. Drehfederelement (100), das drehbar mit einem Substrat (200) verbunden und zum Einsatz in mikro-elektro-mechanischen Vorrichtungen geeignet ist, wobei
das Drehfederelement (100) sowohl gegenüber dem Substrat (200) verdreht als auch linear gegenüber dem Substrat (200) bewegt werden kann;
das Drehfederelement (100) einstückig ausgebildet ist und aufweist:
eine Rahmenstruktur (110);
eine vorzugsweise innerhalb der Rahmenstruktur (110) angeordnete Ankerstruktur (120); und
Federstrukturen (130), die die Ankerstruktur (120) mit der Rahmenstruktur (110) verbinden;
die Ankerstruktur (120) die Federstrukturen (130) und die Rahmenstruktur (110) mit dem Substrat (200) verbindet;
sich die Rahmenstruktur (110) unter Verformung der Federstrukturen (130) als Ganzes gegenüber der Ankerstruktur (120) bewegt, um Drehbewegungen und Linearbewegungen des Drehfederelements (100) gegenüber dem Substrat (200) zu erzeugen; und
die Federstruktur (130) zumindest eine Paarung (135) von zwei Biegebalkenfedern (132) aufweist, die sich von der Ankerstruktur (120) aus unter einem Winkel ungleich 0° erstrecken, **gekennzeichnet dadurch, dass** die zwei Biegebalkenfedern (132) der Paarung (135) jeweils einen Knick (133) aufweisen, nach dem Knick (133) aufeinander zulaufen, an der Rahmenstruktur (110) aufeinandertreffen und dort mit der Rahmenstruktur (110) verbunden sind.

2. Drehfederelement (100) nach Anspruch 1, wobei
die Federstruktur (130) eine Mehrzahl von besagten Paarungen (135) von Biegebalkenfedern (132) aufweist; und
sich benachbarte Biegebalkenfedern (132) von unterschiedlichen Paarungen (135) bis zu dem jeweiligen Knick (133) geradlinig und parallel von der Ankerstruktur (120) aus erstrecken.

3. Drehfederelement (100) nach einem der Ansprüche 1 oder 2, wobei
die Federstruktur (130) eine Mehrzahl von besagten Paarungen (135) von Biegebalkenfedern (132) aufweist; und
sich alle Biegebalkenfedern (132) der unterschiedlichen Paarungen (135) unter dem gleichen Winkel von der Ankerstruktur (120) aus erstrecken.

4. Drehfederelement (100) nach einem der Ansprüche 1 bis 3, wobei
die Rahmenstruktur (110) ein rechteckiger, an einer Längsseite (111) offener Rahmen ist;
die Ankerstruktur (120) ein mit dem Substrat (200) verbundener Sockel ist, der mittig an der offenen Längsseite (111) des Rahmens angeordnet ist;
eine erste Biegebalkenfeder (132a) von dem Sockel aus parallel zur Längsrichtung des Rahmens bis zu einem ersten Ende (112) des Rahmens läuft, dort um 90° abknickt und zu einer ersten Ecke (114) des Rahmens läuft und dort mit dem Rahmen verbunden ist;
eine zweite Biegebalkenfeder (132b) von dem Sockel aus senkrecht zur Längsrichtung zu einer geschlossenen Längsseite (113) des Rahmens läuft, dort um 90° abknickt und zu der ersten Ecke (114) des Rahmens läuft und dort mit dem Rahmen verbunden ist;
eine dritte Biegebalkenfeder (132c) von dem Sockel aus parallel zur Längsrichtung des Rahmens und entgegengesetzt zur ersten Biegebalkenfeder (132a) bis zu einem zweiten Ende (116) des Rahmens läuft, dort um 90° abknickt und zu einer zweiten Ecke (118) des Rahmens läuft und dort mit dem Rahmen verbunden ist; und
eine vierte Biegebalkenfeder (132d) von dem Sockel aus parallel zur zweiten Biegebalkenfeder (132b) senkrecht zur Längsrichtung zu der geschlossenen Längsseite (113) des Rahmens läuft, dort um 90° abknickt und entgegengesetzt zur zweiten Biegebalkenfeder (132b) zu der zweiten Ecke (118) des Rahmens läuft und dort mit dem Rahmen verbunden ist.

5. Drehfederelement (100) nach einem der Ansprüche 1 bis 3, wobei
die Rahmenstruktur (110) ein quadratischer Rahmen ist;
die Ankerstruktur (120) ein im Mittelpunkt des Rahmens mit dem Substrat (200) verbundener Sockel ist; und
acht Biegebalkenfedern (132) in Paaren von je zwei parallel laufenden Biegebalkenfedern (132) von dem Sockel aus in Richtung des Rahmens laufen, am Rahmen um 90° abknicken und parallel zum Rahmen zu der nächstgelegenen Ecke des Rahmens laufen und dort mit dem Rahmen verbunden sind.

6. Drehfederelement (100) nach einem der Ansprüche 1 bis 3, wobei
die Rahmenstruktur (110) ein kreisförmiger Rahmen ist;
die Ankerstruktur (120) ein im Mittelpunkt des Rahmens mit dem Substrat (200) verbundener Sockel ist;
Paare von je zwei parallel laufenden Biegebalken (132) wie die Speichen eines Rades von dem Sockel aus in Richtung des Rahmens laufen, am Rahmen um 90° abknicken und entlang des Rahmens laufen; und
benachbarte Biegebalkenfedern (132) aus benachbarten Paaren sich in der Mitte zwischen ihren jeweiligen Knickstellen (133) treffen und dort mit dem Rahmen verbunden sind.

## Claims

1. A torsion spring element (100) rotatably connected to a substrate (200) and suitable for use in micro-electro-mechanical devices, wherein
the torsion spring element (100) can be twisted relative to the substrate (200), as well as moved linearly relative to the substrate (200);
the torsion spring element (100) is designed in one piece and comprises:
a frame structure (110);
an anchor structure (120) preferably arranged within the frame structure (110); and
spring structures (130) connecting the anchor structure (120) to the frame structure (110);
the anchor structure (120) connects the spring structures (130) and the frame structure (110) to the substrate (200);
the frame structure (110), with deformation of the spring structures (130), moves as a whole relative to the anchor structure (120) to produce rotational movements and linear movements of the torsion spring element (100) relative to the substrate (200); and
the spring structure (130) has at least one pairing (135) of two bending beam springs (132) which extend from the anchor structure (120) at an angle not equal to 0°, **characterized in that** the two bending beam springs (132) of the pairing (135) each have a kink (133), converge towards each other after the kink (133), meet at the frame structure (110), and are connected to the frame structure (110) at that point.

2. The torsion spring element (100) according to claim 1, wherein
the spring structure (130) comprises a plurality of said pairings (135) of bending beam springs (132); and
adjacent bending beam springs (132) of different pairings (135) extend straight and in parallel from the anchor structure (120) to the respective kink (133).

3. The torsion spring element (100) according to either claim 1 or 2, wherein
the spring structure (130) comprises a plurality of said pairings (135) of bending beam springs (132); and
all bending beam springs (132) of the different pairings (135) extend at the same angle from the anchor structure (120).

4. The torsion spring element (100) according to any one of claims 1 to 3, wherein
the frame structure (110) is a rectangular frame open on one longitudinal side (111);
the anchor structure (120) is a base connected to the substrate (200) and located centrally on the open longitudinal side (111) of the frame;
a first bending beam spring (132a) runs from the base parallel to the longitudinal direction of the frame to a first end (112) of the frame, kinks at 90° there and runs to a first corner (114) of the frame and is connected to the frame at that point;
a second bending beam spring (132b) runs from the base perpendicular to the longitudinal direction to a closed longitudinal side (113) of the frame, kinks at 90° there and runs to the first corner (114) of the frame and is connected to the frame at that point;
a third bending beam spring (132c) runs from the base parallel to the longitudinal direction of the frame and opposite to the first bending beam spring (132a) to a second end (116) of the frame, kinks at 90° there and runs to a second corner (118) of the frame and is connected to the frame at that point; and
a fourth bending beam spring (132d) runs from the base parallel to the second bending beam spring (132b) perpendicular to the longitudinal direction to the closed longitudinal side (113) of the frame, kinks at 90° there and runs opposite to the second bending beam spring (132b) to the second corner (118) of the frame and is connected to the frame at that point.

5. The torsion spring element (100) according to any one of claims 1 to 3, wherein
the frame structure (110) is a square frame;
the anchor structure (120) is a base connected to the substrate (200) at the center of the frame; and
eight bending beam springs (132) in pairs of two parallel running bending beam springs (132) each run from the base towards the frame, kink at 90° at the frame and run parallel to the frame to the nearest corner of the frame and are connected to the frame at that point.

6. The torsion spring element (100) according to any one of claims 1 to 3, wherein
the frame structure (110) is a circular frame;
the anchor structure (120) is a base connected to the substrate (200) at the center of the frame;
pairs of two parallel running bending beams (132) each running like the spokes of a wheel from the base towards the frame, kinking at 90° at the frame and running along the frame; and
adjacent bending beam springs (132) from adjacent pairs meet in the middle between their respective kink points (133) and are connected to the frame at that point.

## Revendications

1. Élément de ressort de torsion (100), qui est relié avec possibilité de rotation à un substrat (200) et est apte à être utilisé dans des dispositifs micro-électromécaniques, dans lequel
l'élément de ressort de torsion (100) peut aussi bien être tourné par rapport au substrat (200) qu'être déplacé linéairement par rapport au substrat (200) ;
l'élément de ressort de torsion (100) est réalisé d'un seul tenant et présente :
une structure de cadre (110) ;
une structure d'ancrage (120) disposée de préférence à l'intérieur de la structure de cadre (110) ; et
des structures de ressort (130), qui relient la structure d'ancrage (120) à la structure de cadre (110) ;
la structure d'ancrage (120) relie les structures de ressort (130) et la structure de cadre (110) au substrat (200) ;
la structure de cadre (110) se déplace en déformant les structures de ressort (130) comme un tout par rapport à la structure d'ancrage (120) pour produire des déplacements par rotation et des déplacements linéaires de l'élément de ressort de torsion (100) par rapport au substrat (200) ; et
la structure de ressort (130) présente au moins un appariement (135) de deux ressorts à barre de flexion (132) qui s'étendent en partant de la structure d'ancrage (120) selon un angle autre que 0°, **caractérisé en ce que** les deux ressorts à barre de flexion (132) de l'appariement (135) présentent chacun un coude (133), convergent l'un vers l'autre après le coude (133), se rencontrent en la structure de cadre (110) et là sont reliés à la structure de cadre (110).

2. Élément de ressort de torsion (100) selon la revendication 1, dans lequel
la structure de ressort (130) présente une pluralité de dits appariements (135) de ressorts à barre de flexion (132) ; et
des ressorts à barre de flexion (132) adjacents de différents appariements (135) s'étendent en partant de la structure d'ancrage (120) de manière rectiligne et de manière parallèle jusqu'au coude (133) respectif.

3. Élément de ressort de torsion (100) selon l'une des revendications 1 ou 2, dans lequel
la structure de ressort (130) présente une pluralité de dits appariements (135) de ressorts à barre de flexion (132) ; et
tous les ressorts à barre de flexion (132) des différents appariements (135) s'étendent en partant de la structure d'ancrage (120) selon le même angle.

4. Élément de ressort de torsion (100) selon l'une des revendications 1 à 3, dans lequel
la structure de cadre (110) est un cadre rectangulaire ouvert sur un côté longitudinal (111) ;
la structure d'ancrage (120) est un socle relié au substrat (200) qui est disposé au milieu sur le côté longitudinal ouvert (111) du cadre ;
un premier ressort à barre de flexion (132a) s'étend parallèlement à la direction longitudinale du cadre en partant du socle jusqu'à une première extrémité (112) du cadre, là bifurque de 90° et s'étend vers un premier coin (114) du cadre et là est relié au cadre ;
un deuxième ressort à barre de flexion (132b) s'étend perpendiculairement à la direction longitudinale en partant du socle vers un côté longitudinal fermé (113) du cadre, là bifurque de 90° et s'étend vers le premier coin (114) du cadre et là est relié au cadre ;
un troisième ressort à barre de flexion (132c) s'étend parallèlement à la direction longitudinale du cadre et à l'opposé du premier ressort à barre de flexion (132a) en partant du socle jusqu'à une deuxième extrémité (116) du cadre, là bifurque de 90° et s'étend vers un deuxième coin (118) du cadre et là est relié au cadre ; et
un quatrième ressort à barre de flexion (132d) s'étend parallèlement au deuxième ressort à barre de flexion (132b) perpendiculairement à la direction longitudinale en partant du socle vers le côté longitudinal fermé (113) du cadre, là bifurque de 90° et s'étend à l'opposé du deuxième ressort à barre de flexion (132b) vers le deuxième coin (118) du cadre et là est relié au cadre.

5. Élément de ressort de torsion (100) selon l'une des revendications 1 à 3, dans lequel
la structure de cadre (110) est un cadre carré ;
la structure d'ancrage (120) est un socle relié au substrat (200) au centre du cadre ; et
huit ressorts à barre de flexion (132) s'étendent à chaque fois par paires de deux ressorts à barre de flexion (132) s'étendant parallèlement en partant du socle en direction du cadre, au cadre bifurquent de 90° et s'étendent parallèlement au cadre vers le coin le plus proche du cadre et là sont reliés au cadre.

6. Élément de ressort de torsion (100) selon l'une des revendications 1 à 3, dans lequel
la structure de cadre (110) est un cadre circulaire ;
la structure d'ancrage (120) est un socle relié au substrat (200) au centre du cadre ;
des paires de barres de flexion (132) s'étendant parallèlement s'étendent comme les rayons d'une roue en partant du socle en direction du cadre, au cadre bifurquent de 90° et s'étendent le long du cadre ; et
des ressorts à barre de flexion (132) adjacents provenant de paires adjacentes se rencontrent au milieu entre leurs emplacement de coude (133) respectifs et là sont reliés au cadre.
